(19) Europäisches Patentamt
European Patent Office
Office européen des brevets

(11) Publication number: 0 254 230 A2

(12) EUROPEAN PATENT APPLICATION

(21) Application number: 87110407.1

(22) Date of filing: 17.07.87

(51) Int.Cl.³: G 03 F 7/10
G 03 C 1/68

(30) Priority: 22.07.86 JP 172623/86
22.07.86 JP 172624/86
22.07.86 JP 172625/86

(43) Date of publication of application: 27.01.88 Bulletin 88/4

(84) Designated Contracting States: CH DE FR GB IT LI NL

(71) Applicant: Asahi Kasei Kogyo Kabushiki Kaisha
2-6, Dojimahama 1-chome Kita-ku
Osaka-shi Osaka 530(JP)

(72) Inventor: Ai, Hideo
4-2, Asahi Kasei-Naka-Shataku 351-1, Samejima
Fuji-shi Shizuoka-ken(JP)

(72) Inventor: Ikeda, Akihiko
3588-19, Imaizumi
Fuji-shi Shizuoka-ken(JP)

(72) Inventor: Yokota, Kan-ichi
A-14, Endo-Apartment 68, Aoshima-cho
Fuji-shi Shizuoka-ken(JP)

(74) Representative: Strehl, Schübel-Hopf, Groening, Schulz
Widenmayerstrasse 17 Postfach 22 03 45
D-8000 München 22(DE)

(54) **Heat-resistant photoresist film.**

(57) A heat-resistant photoresist film comprising, as the essential components,

(a) a polymer consisting of recurring units represented by the formula

$$\underset{(A)_2}{\underset{|}{-X}}-Z-Y-Z- \qquad (I)$$

wherein

X is a tetravalent $C_{6-30}$ carbocyclic group or heterocyclic group;

Y is a divalent $C_{6-30}$ carbocyclic group or heterocyclic group;

Z is $-\underset{\overset{\|}{O}}{C}-NH-$, $-NH-\underset{\overset{\|}{O}}{C}-NH-$ or $-O-\underset{\overset{\|}{O}}{C}-NH-$;

A is $-COOR$ or $-COO^{\ominus}R'^{\oplus}$ wherein each of R and R' is a compound having a reactive carbon-carbon double bond; and

A is in the position ortho or peri with respect to the Z group,

said polymer being capable of transforming into a polymer having a thermal decomposition temperature of at least 350 °C and a glass transition temperature of at most 350 °C in the heat treatment;

(b) a compound having a reactive carbon-carbon double bond; and

(c) a photopolymerization initiator.

EP 0 254 230 A2

# BACKGROUND OF THE INVENTION

## FIELD OF THE INVENTION

The present invention relates to a novel heat-resistant photoresist film.

In recent years, extensive studies have been made to develop heat-resistant photosensitive polymeric materials for use as electronic or optical components. Such components include: surface-protecting films, e.g. junction coatings, passivation films, buffer coatings and α-particle protecting films; insulation films for semiconductor devices, e.g. insulation films between layers for multilayer circuits; molecular-oriented films for liquid crystal display devices; and insulation films for thin-film magnetic heads or for multilayer printed circuit boards.

## DESCRIPTION OF THE PRIOR ART

Heretofore, as the heat-resistant photosensitive compositions are known compositions capable of forming a crosslinking structure which comprise a polyamic acid which is a polyimide precursor and photosensitive compound or a polymer prepared by introducing an active functional group such as a double-bond containing group onto the ester side chains of a polyamic acid which is a photosensitive polyimide precursor, a photopolymerization initiator and a crosslinking monomer (U.S. Patent Nos. 3,957,512 and 4,287,294). These compositions are basic compositions for heat-resistant polymeric materials for lithography as represented by photosensitive polyimides. As the conventional method for forming an image using these compositions, a solution of the compositions is applied on a substrate by means of a roll coater, a spin coater, a curtain coater

and so on, and after drying, the resist coating thus formed is exposed to actinic irradiation through a photomask and developed with an organic solvent to form an image on the substrate. When the photosensitive polyimide precursor is employed as a solution varnish, it requires a solvent of a high boiling point and accordingly, if the resist coating is thick, the drying time tends to be long disadvantageously. Also, when the liquid photosensitive polyimide precursor is applied on a substrate by means of a spin coater, it is difficult to form a coating of uniform thickness all over the substrate and as a result, the peripheral area is thicker than the central area. Thus, the yield of application on the substrate tends to be low. As a photosensitive material for producing printed circuit boards there is known a dry film photoresist consisting of a film support and a photosensitive layer disposed thereon. In forming an image on a substrate, the photosensitive dry film resist is laminated onto a substrate with heating under pressure and thus, advantageously the drying procedure which is necessary in screen printing is omitted and a coating of uniform thickness on the substrate can be obtained. Among these photosensitive dry films is known a solder-mask film as a laminate of heat-resistant photosensitive compositions. However, the heat-resistance of this solder-mask film only withstands the soldering temperature and is not suitable for applications which require a heat-resistance of higher than 350 $^{o}$C.

## SUMMARY OF THE INVENTION

It is an object of this invention to provide a heat-resistant photoresist film capable of forming fine heat-resistant patterns in a simple procedure in the fields of surface-protecting films, insulation films and

other various heat-resistant parts of electronic or optical devices.

Other objects of this invention will become apparent from the following description.

According to this invention there is provided a heat-resistant photoresist film comprising, as the essential components,

(a) a polymer consisting of recurring units represented by the formula

$$-\underset{(A)_2}{\underset{|}{X}}-Z-Y-Z- \qquad [I]$$

wherein X is a tetravalent $C_{6-30}$ carbocyclic group or heterocyclic group;

Y is a divalent $C_{6-30}$ carbocyclic group or heterocyclic group;

Z is $-\underset{\underset{O}{\|}}{C}-NH-$, $-NH-\underset{\underset{O}{\|}}{C}-NH-$ or $-O-\underset{\underset{O}{\|}}{C}-NH-$;

A is $-COOR$ or $-COO^{\ominus}R'^{\oplus}$ wherein each of R and R' is a compound having a reactive carbon-carbon double bond; and

A is in the position ortho or peri with respect to the Z group,

said polymer being capable of transforming into a polymer having a thermal decomposition temperature of at least 350 $^{o}C$ and a glass transition temperature of at most 350 $^{o}C$ in the heat treatment;

(b) a compound having a reactive carbon-carbon double bond; and

(c) a photopolymerization initiator.

DESCRIPTION OF THE PREFERRED EMBODIMENTS

The polymer used as component (a) in the heat-resistant photoresist film of this invention consists of structural repeating units represented by the above described formula [I], wherein X is a tetravalent $C_{6-30}$ carbocyclic or heterocyclic group. Examples of X are a tetravalent aromatic ring such as a benzene ring and a toluene ring; a tetravalent condensed polycyclic ring such as a naphthalene ring and an anthracene ring; a tetravalent heterocyclic group such as pyridine, methylpyridine and thiophene; and a group having the following formula

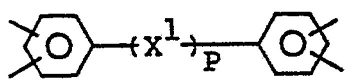 [Ia]

wherein $X^1$ is $-CH_2-$, $-\overset{O}{\overset{\|}{C}}-$, $-\overset{O}{\overset{\|}{\underset{\underset{O}{\|}}{S}}}-$, $-O-$ or $-\overset{CF_3}{\overset{|}{\underset{\underset{CF_3}{|}}{C}}}-$ and p is 0 or 1. Exemplary groups of the formula [Ia] are:

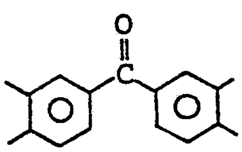 , 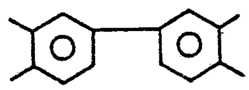 , 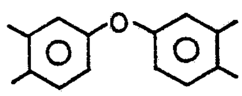 , 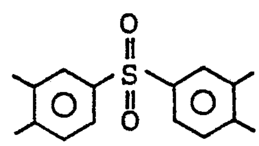

and 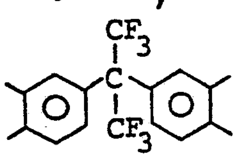 .

Of these groups, 3,3',4,4'-substituted benzophenones or biphenyls are preferred in view of the heat resistance of the polymer and the glass transition temperature of the polymer after heat treatment.

Y in the formula [I] is a divalent $C_{6-30}$ carbocyclic or heterocyclic group. Examples of Y are a divalent aromatic ring such as a benzene ring, a toluene ring, a xylene ring and a trimethylbenzene, a divalent

condensed polycyclic ring such as a naphthalene ring and an anthacene ring; a divalent heterocyclic ring derived from pyridine,methylpryridine and imidazole and one of the groups represented by the following formulae

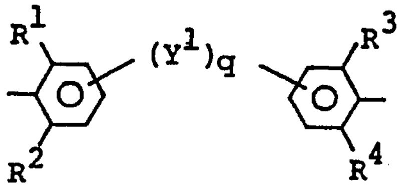 [IIa], 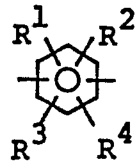 [IIb]

wherein $Y^1$ is $-CH_2-$ , 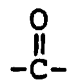 , 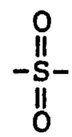 , -O- , -S-

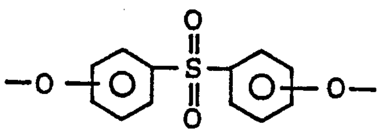 , 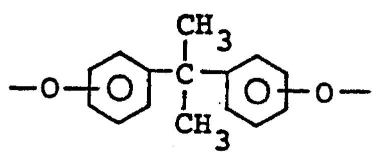

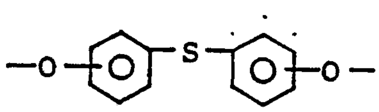 or 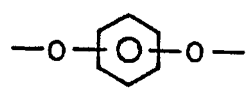 ;

each of $R^1$, $R^2$, $R^3$ and $R^4$ is a hydrogen atom, a $C_{1-6}$ alkyl group or $-CONH_2$; and q is 0 or 1.

Exemplary groups of these formulae are:

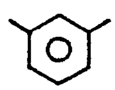 , 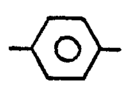 , 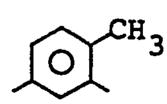 ,

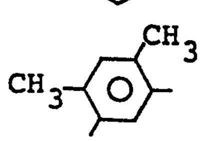 , 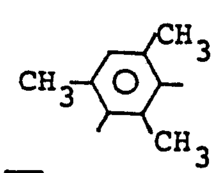 , 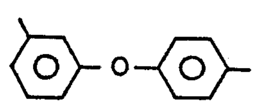 ,

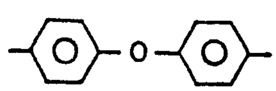 , 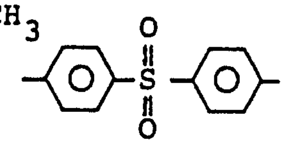 , 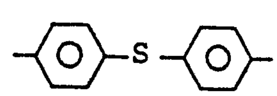 ,

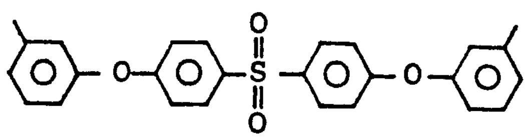 , 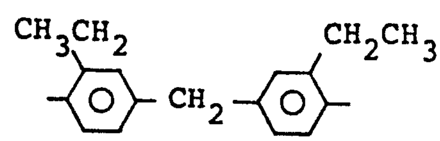 ,

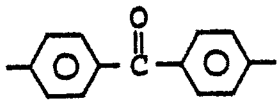 , 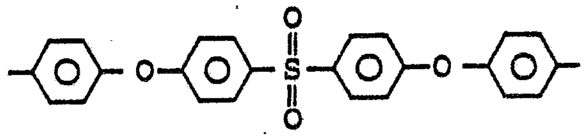 ,

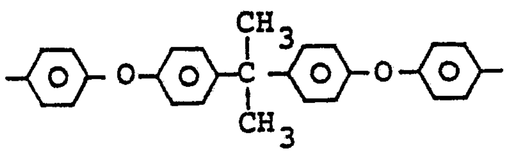 , 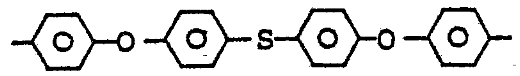 ,

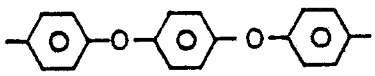 , 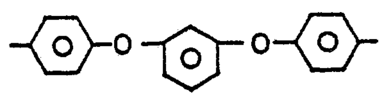 , 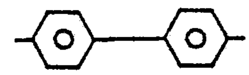 ,

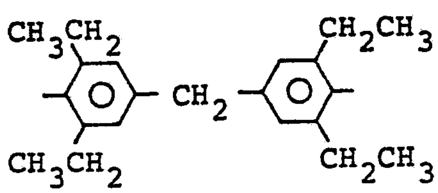 , 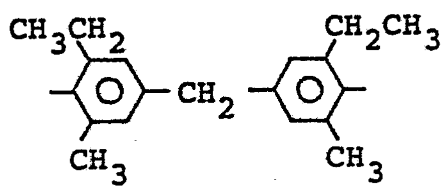 and

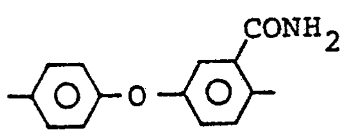 .

Of these groups is preferred the group of the following formula [IIc] in view of the heat resistance of the polymer and the glass transition temperature of the polymer after heat treatment.

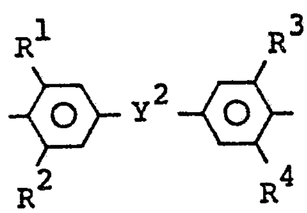 [IIc]

wherein $Y^2$ is $-CH_2-$ or $-O-$ and each of $R^1$, $R^2$, $R^3$ and $R^4$ is a hydrogen atom or a $C_{1-6}$ alkyl group.

Z in the formula [I] is $-\overset{O}{\overset{\|}{C}}-NH-$, $-NH-\overset{O}{\overset{\|}{C}}-NH-$ or $-O-\overset{O}{\overset{\|}{C}}-NH-$ . Of these groups, the $-\overset{O}{\overset{\|}{C}}-NH-$ group capable of transforming into an imide ring in the heat treatment is especially preferred.

R in the A of the formula [I] is represented by the following formula

$$-R^6\left(W-\overset{O}{\overset{\|}{C}}\right)_r\overset{R^5}{\overset{|}{C}}=CH_2 \qquad [III]$$

wherein $R^5$ is a hydrogen atom or a methyl group $R^6$ is an alkyl group which may have an ether bond or a hydroxyl group; W is -O- or -NH- ; and r is 0 or 1).

Exemplary groups of the formula [III] are:

$-CH_2CH_2-O-\overset{O}{\overset{\|}{C}}-CH=CH_2$ , $-CH_2CH_2-O-\overset{O}{\overset{\|}{C}}-\overset{CH_3}{\overset{|}{C}}=CH_2$ ,

$-CH_2\overset{OH}{\overset{|}{C}}HCH_2-O-\overset{O}{\overset{\|}{C}}-\overset{CH_3}{\overset{|}{C}}=CH_2$ , $\left(CH_2CH_2O\right)_s\overset{O}{\overset{\|}{C}}-\overset{CH_3}{\overset{|}{C}}=CH_2$ , $-CH_2-CH=CH_2$ ,

(wherein s is 2 or 4)

$-CH_2CH_2-CH=CH_2$ , $-CH_2NH\overset{O}{\overset{\|}{C}}-CH=CH_2$ and $-CH_2NH\overset{O}{\overset{\|}{C}}-\overset{CH_3}{\overset{|}{C}}=CH_2$. Of the above described groups, are preferred 2-methacryloxyethyl group and 2-acryloxyethyl group in view of the photosensitivity and developing property of the polymer.

When A in the formula [I] is $-COO^{\ominus}R'^{\oplus}$, $R'^{\oplus}$ is represented by the following formula

$$R8-\overset{R^7}{\underset{R^9}{\overset{|}{\underset{|}{N^{\oplus}}}}}-R^6\left(O-\overset{O}{\overset{\|}{C}}\right)_r\overset{R^5}{\overset{|}{C}}=CH_2 \qquad [IV]$$

wherein each of $R^7$, $R^8$ and $R^9$ is a hydrogen atom or a $C_{1-6}$ alkyl group; and $R^5$, $R^6$ and r are the same as defined in the formula [III]. Preferred examples are:

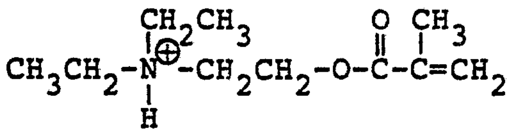 , 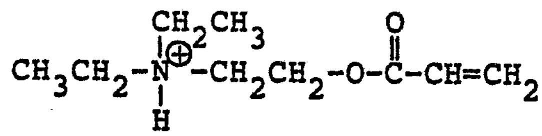 ,

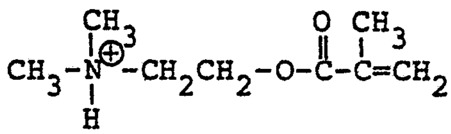 and 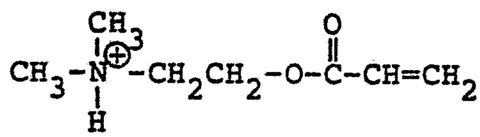 .

The polymer used as component (a) in the heat-resistant photoresist film can be prepared by the condensation polymerization or the addition polymerization of a compound represented by the general formula

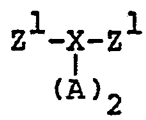 [V]

and a compound represented by the general formula

$$Z^2-Y-Z^2 \qquad [VI]$$

Examples of $Z^1$ in the formula [V] include -COOH, -COCℓ, -NCO, $-NH_2$ and -OH and examples of $Z^2$ in the formula [VI] include -COCℓ, -COOH, -NCO and $-NH_2$. X, A and Y are the same as defined above.

Z is formed by the reaction of $Z^1$ and $Z^2$ in the condensation polymerization and the addition polymerization of the compound represented by the formula [V] and the compound represented by the formula [VI]. Suitable combinations of $Z^1$ and $Z^2$; Z formed; and ring structures formed in the heat treatment of the polymers formed are set forth in Table 1.

Table 1

| No. | $Z^1$ | $Z^2$ | Z | Ring structure |
|---|---|---|---|---|
| 1 | -COOH | -NH2 | $-\overset{O}{\overset{\|}{C}}-NH-$ | imide ring |
| 2 | -COCℓ | -do- | -do- | -do- |
| 3 | -COCℓ | -NCO | -do- | -do- |
| 4 | -NCO | -COOH | -do- | ——— |
| 5 | $-NH_2$ | -NCO | $-NH-\overset{O}{\overset{\|}{C}}-NH-$ | quinazoline dione ring |
| 6 | $-NH_4$ | -COOH | $-\overset{O}{\overset{\|}{C}}-NH-$ | ——— |
| 7 | -OH | -NCO | $-O-\overset{O}{\overset{\|}{C}}-NH-$ | oxazine dione ring |

For example, the compound of the formula [V] wherein $Z^1$ is -COOH, can be prepared by the ring-opening reaction of an acid dianhydride represented by the formula

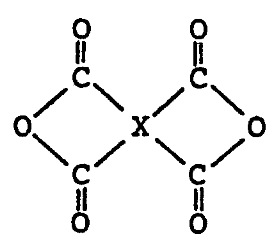

$[V^1]$

wherein X is the same as defined above, and an alcohol represented by the formula ROH wherein R is the same as defined above.

Of the combinations of the compound of the formula [V] and the compound of the formula [VI], preferred is a combination of the compound of the formula [V] wherein $Z^1$ is -COOH and the compound of the formula [VI] wherein $Z^2$ is $-NH_2$. This reaction can be carried out by using a carbodiimide such as dicyclohexylcarbodiimide as the dehydration condensing agent. Suitable solvents for this reaction are aprotic polar solvents including, for example, N,N-dimethylformamide, hexamethylphosphorotriamide, N-methylpyrrolidone, N,N-dimethylacetamide, tetrahydrofuran and γ-butyrolactone. The reaction is carried out at a temperature of -20 °C to 80 °C, preferably -10 °C to 30 °C, for 1 to 100 hours, preferably 2 to 24 hours, under continuous stirring. The method for preparing polyamides with the use of a carbodiimide is described in U.S. Patent No. 4,645,823 and this method can be advantageously employed in this invention.

According to this method the molecular weight of the polymers can be controlled by varying the mol ratio of the compound of the formula [V] wherein $Z^1$ is -COOH and the compound of the formula [VI] wherein $Z^2$ is $-NH_2$. Further, when the reaction is carried out by using an excess amount of one of these two compounds, it is preferred to add a capping agent for remaining terminals. As the capping agent preferred are alcohols such as methanol and ethanol and amines such as butylamine and aniline when the compound of the formula [V] is in excess.

In the separation of the polymer formed from the reaction mixture, it is preferred to add an alcohol little by little to the reaction mixture. The purification of the polymer is carried out by dissolving the solid polymer thus separated in a solvent such as

tetrahydrofuran and adding the solution little by little to water to precipitate a polymer.

The compound of the formula [V] wherein $Z^1$ is -COCℓ, can be prepared by the reaction of the half ester of the compound of the formula [V] wherein $Z^1$ is -COOH, and thionyl chloride or phosphorus pentachloride.

In the reaction of the compound of the formula [V] wherein $Z^1$ is COCℓ and the compound of the formula [VI] wherein $Z^2$ is $-NH_2$, the same solvent as used in the reaction of the compound of the formula [V] wherein $Z^1$ is -COOH and the compound of the formula [VI] wherein $Z^2$ is $-NH_2$, can be employed. However, when tetrahydrofuran or γ-butyrolactone is employed, it is necessary to employ an amine such as pyridine and triethylamine as the dehydrochlorination agent. In the separation of the polymer formed from the reaction mixture it is preferred to add the reaction mixture little by little to a large amount of water. The purification of the polymer is carried out by pulverizing the solid polymer thus separated and washing the pulverized polymer with water or by repeating the steps of dissolving the solid polymer in an organic solvent and adding the solution to water to precipitate a polymer.

Further, the polymer used as component (a) of the photoresist film of this invention can be prepared by firstly reacting an acid dianhydride of the formula [$V^1$] with the compound of the formula [VI] wherein $Z^2$ is $-NH_2$, in the solvent as described above with continuous stirring at a temperature of -10 °C to 30 °C for 2 to 24 hours to prepare a polyamic acid and secondly reacting the polyamic acid with a compound having an epoxy ring represented by the formula

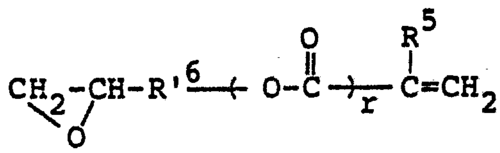 [VII]

wherein $R^5$ is a hydrogen atom or a methyl group; $R'^6$ is an alkyl group which may have an ether bond; r is 0 or 1, to effect esterification by opening the epoxy ring with free carboxyl groups at a temperature of 20 °C to 90 °C for 2 to 96 hours in the solvent as described above.

Examples of the compound of the formula [VII] include glycidyl methacrylate and glycidyl acrylate.

The polymer used as component (a) of the photoresist film wherein A is $-COO^{\ominus}R'^{\oplus}$ can be prepared by reacting the polyamic acid as described above with a compound represented by the formula

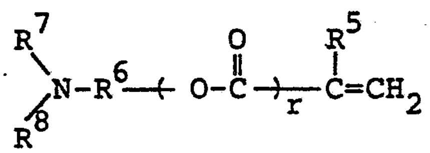 [$VII^1$]

wherein $R^5$ is a hydrogen atom or a $C_{1-6}$ alkyl group; $R^6$ is an alkyl group which may have an ether bond or a hydroxyl group; and r is 0 or 1.

Examples of the compound of the formula [$VII^1$] include:

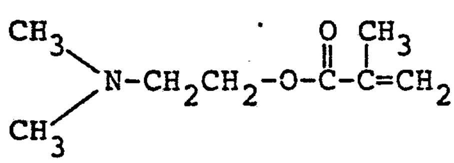 ,

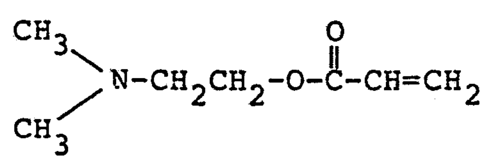

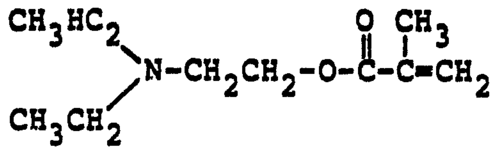 and 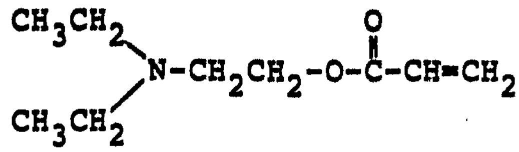 .

The polymer which can be employed in the heat-resistant photoresist film is capable of transforming into a polymer having a thermal decomposition temperature of at least 350 °C and a glass transition temperature of at most 350 °C in the heat treatment. This heat treatment is carried out at such a temperature as to volatilize the compound having a reactive carbon-carbon double bond, the photopolymerization initiator and silane coupling agent if employed, and to substantially convert the polymer to a polymer having heat-resistant structure units of imide rings, quinazoline dione rings and oxazine dione rings. The polymer which is capable of transforming into a polymer having a glass transition temperature of at most 350 °C has a relatively low glass transition temperature and imparts sufficient adhesiveness to the photoresist film at a practical temperature range where thermal polymerization does not occur at the lamination of the photoresist film onto a substrate.

In this invention the thermal decomposition temperature is obtained by applying a 40 wt% solution of a polymer in a mixed solvent of N-methylpyrrolidone and cyclopentanone (volume ratio 1:1) onto a glass sheet substrate to form a coating film, drying the coating film to a uniform thickness of 50  m at 70 °C for 30 minutes, subjecting the coating film thus prepared to heat treatment at 140 °C for 2 hours and 400 °C for one hour in a nitrogen atmosphere and measuring the weight of the heat-treated coating film by differential thermal gravimetry under the condition of elevating temperature at a rate of 10 °C per minute in a nitrogen atmosphere.

The glass transition temperature is obtained from the temperature showing an inflection point of the coefficient of linear expansion which is obtained by measuring the elongation of the above-described heat-treated coating film by a thermal mechanical analyser under the condition of elevating temperature at a rate of 5 $^{o}C$ and a constant load of 10 g.

Examples of preferred polymers of this invention are:

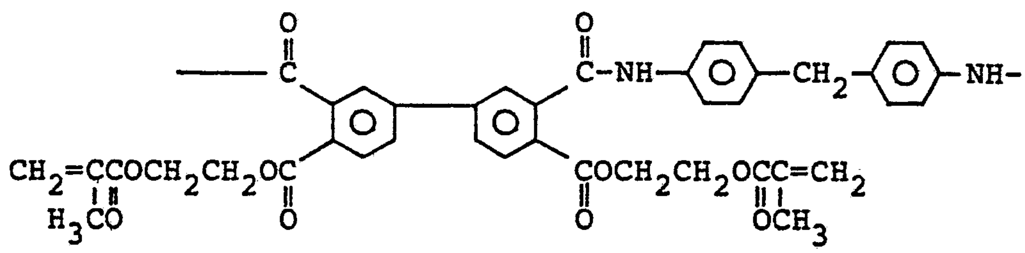

[$P^1$]

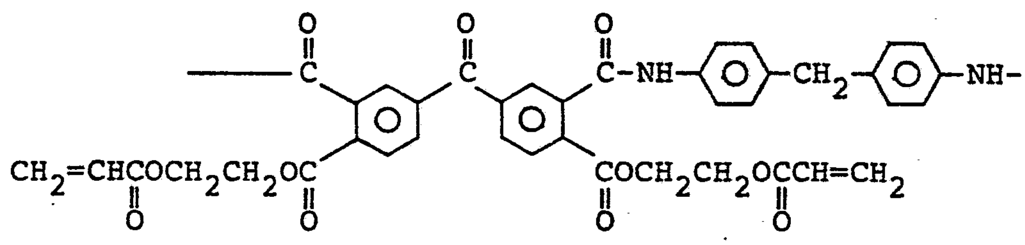

[$P^2$]

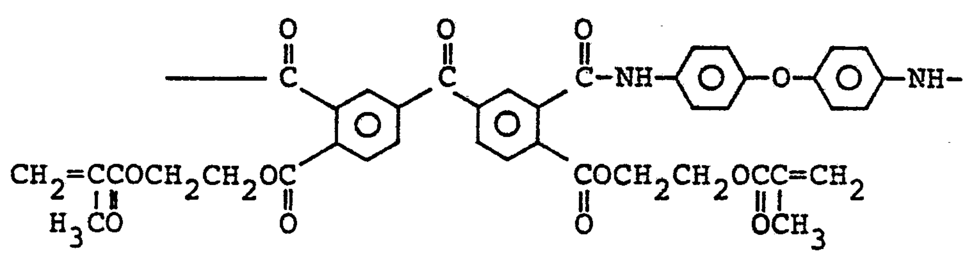

[$P^3$]

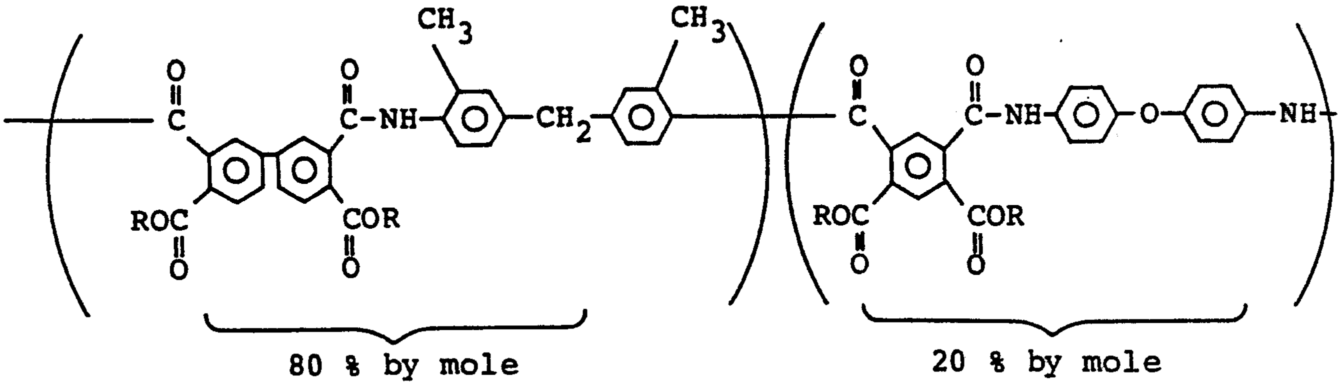

80 % by mole 20 % by mole

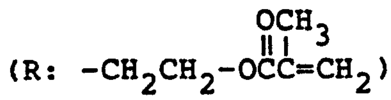

[P4]

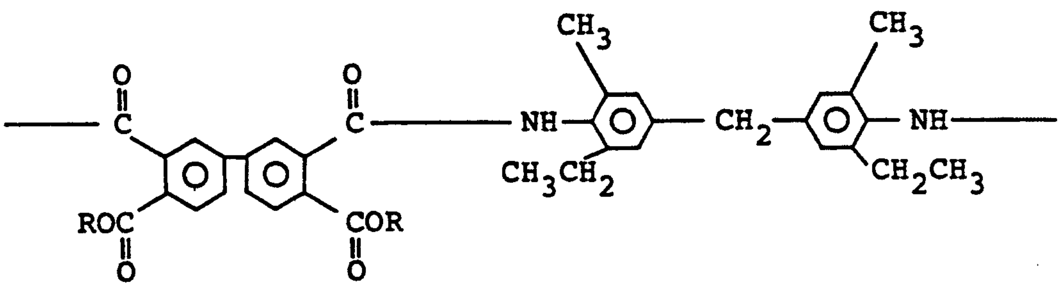

[P5]

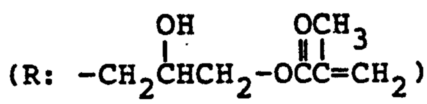

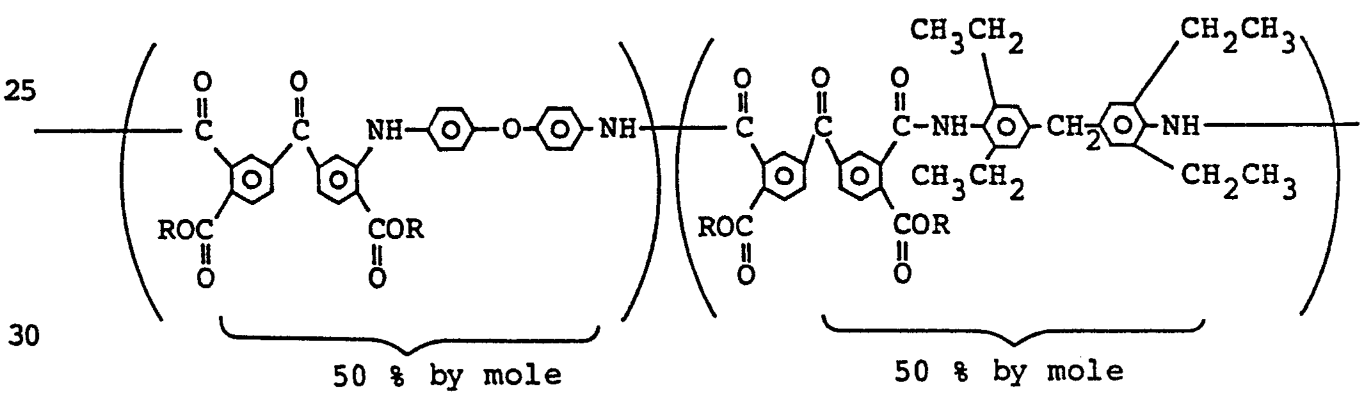

50 % by mole 50 % by mole

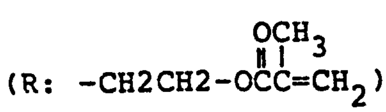

[P6]

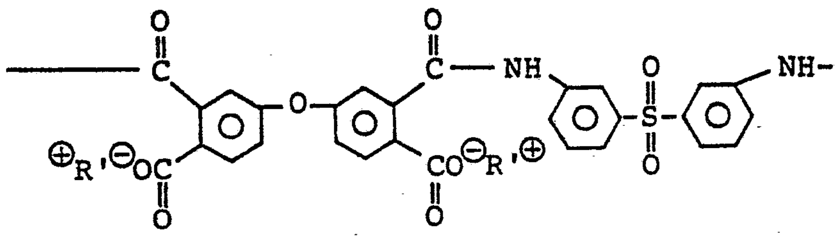

[$P^7$]

[R: 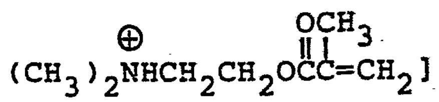 ]

Of these polymer, the polymer capable of transforming into a polymer having a glass transition temperature of 330 °C or less in the heat treatment further improves the adhesiveness of the polymer to a substrate. Examples of such polymers are polymers represented by the formulae [$P^2$], [$P^3$] and [$P^6$].

Also, when the polymer capable of transforming into a polymer having a thermal decomposition temperature of 400 °C or more and a glass transition temperature of 350 °C or less in the heat treatment is employed, the heat resistance of the photoresist film can be more increased. Examples of such polymers are [$P^1$], [$P^2$] and [$P^3$].

The compound having a reactive carbon-carbon double bond used as component (b) in the heat-resistant photoresist film of this invention not only improves the photosensitivity of the photoresist film but also imparts sufficient adhesiveness to the photoresist film with a substrate as well as sufficient close adhesion at the parts of difference in level without evolving micro air at the time of laminating the photoresist film onto the substance.

As the compound having a reactive carbon-carbon double bond, the compound having a terminal group represented by the formula

$$-R^{10}-\overset{O}{\overset{\|}{C}}-\overset{R^{11}}{\overset{|}{C}}=CH \qquad [M^1]$$

wherein $R^{10}$ is -O- or -NH- and $R^{11}$ is a hydrogen atom or a $-CH_3$ group) can be employed. Exemplary compounds include:

$CH_2=CH\overset{O}{\overset{\|}{C}}NHCH_2OH$ , $CH_3CH_2C(CH_2O\overset{O}{\overset{\|}{C}}CH=CH_2)_3$ ,

$CH_2=CH\overset{O}{\overset{\|}{C}}(OCH_2CH_2)_vO\overset{O}{\overset{\|}{C}}CH=CH_2$ (wherein v is an integer of 2 to 14), $CH_2=CH\overset{O}{\overset{\|}{C}}NHCH_2NH\overset{O}{\overset{\|}{C}}CH=CH_2$ , $CH_2=CH\overset{O}{\overset{\|}{C}}O(CH_2)_6O\overset{O}{\overset{\|}{C}}CH=CH_2$ ,

$CH_2=CH\overset{O}{\overset{\|}{C}}OCH_2\overset{CH_3}{\overset{|}{C}}HO\overset{O}{\overset{\|}{C}}NH(CH_2)_6NH\overset{O}{\overset{\|}{C}}O\overset{CH_3}{\overset{|}{C}}HCH_2O\overset{O}{\overset{\|}{C}}CH=CH_2$ ,

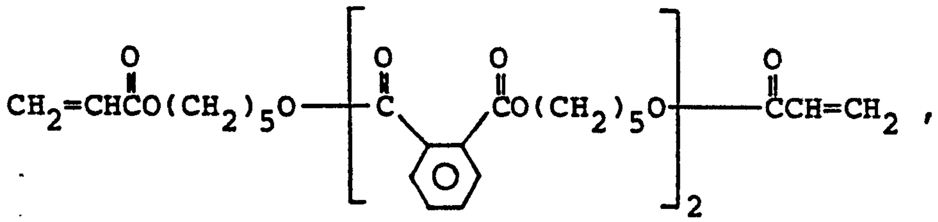

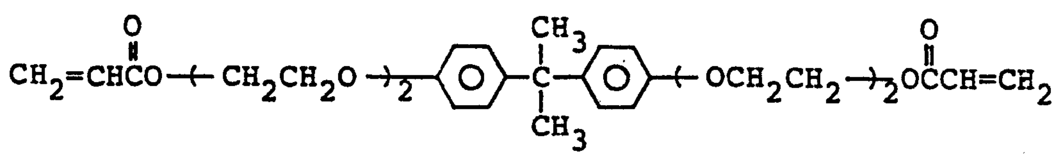

$C(CH_2O\overset{O}{\overset{\|}{C}}CH=CH_2)_4$ ,

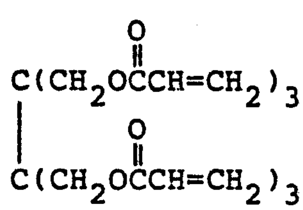

and the compounds where the CH2=CH- group in the above described compounds is replaced by a $CH2=\overset{CH_3}{\overset{|}{C}}-$ group. Of these compounds, preferred are compounds having

plurality of acryloxy groups in view of the photosensitivity of the photoresist film.

As the photopolymerization initiator used as component (c) in the heat-resistant photoresist film of this invention, an oxime type initiator is effective and is preferred a compound represented by the formula

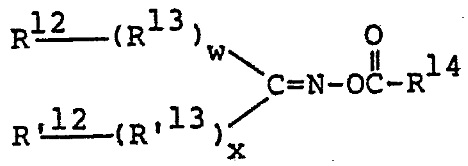 [VIII]

wherein each of $R^{12}$ and $R'^{12}$ is a $C_{1-6}$ alkyl group, a $C_{6-20}$ aromatic hydrocarbon or a group represented by the formula 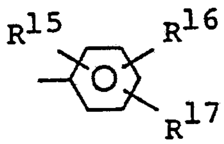 (wherein each of $R^{15}$, $R^{16}$ and $R^{17}$ is a hydrogen atom, a $C_{1-6}$ alkyl group or a $C_{1-6}$ alkoxy group; each of $R^{13}$ and $R'^{13}$ is 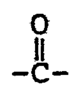, 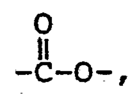, 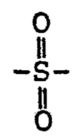 or 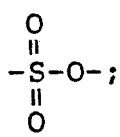; $R^{14}$ is a $C_{1-6}$ alkyl group, a $C_{1-6}$ alkoxy group or an aromatic hydrocarbon of 6 to 20 carbon atoms; and each of w and x is 0 or 1.

Exemplary compounds include:

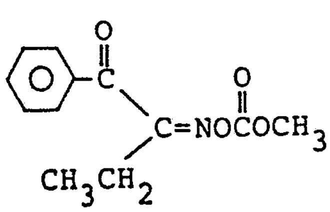 , 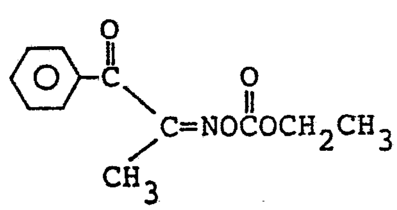 ,

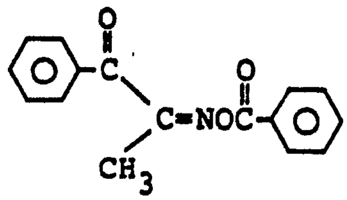 ,

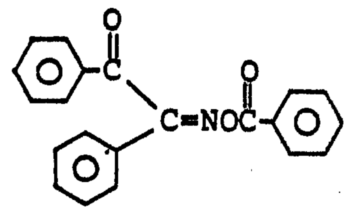 ,

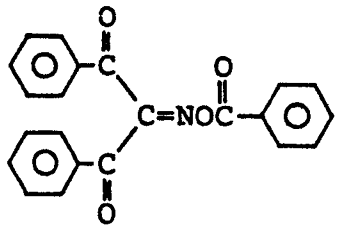 ,

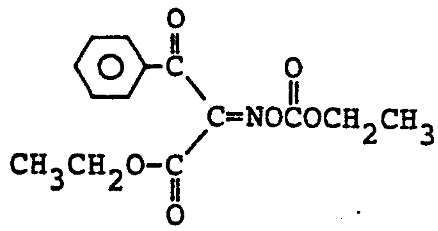 ,

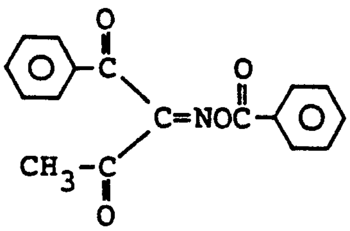 ,

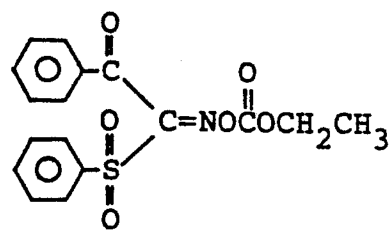 ,

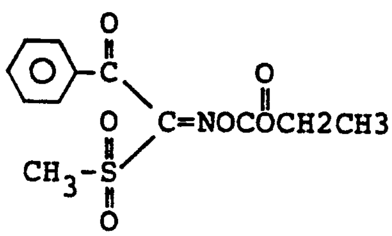 ,

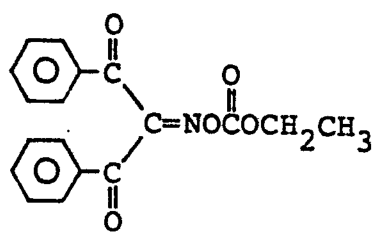 ,

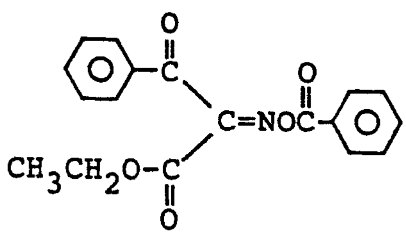 ,

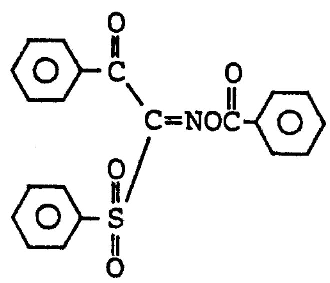 and

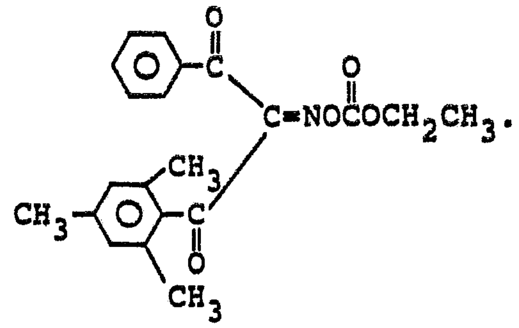

Of these compounds, is preferred a compound represented by the following formula in view of the photosensitivity.

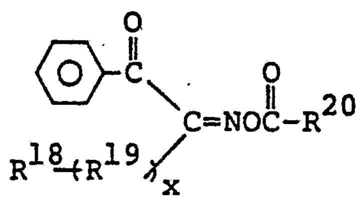

[VIIIa]

wherein $R^{18}$ is $-CH_3$, $-OCH_2CH_3$, 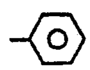 or 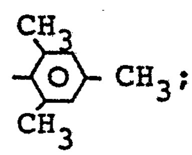;

$R^{19}$ is 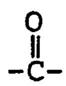 or 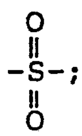; $R^{20}$ is 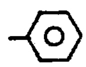 or $-OCH_2CH_3$; and

x is 0 or 1.

The use of a compound having a tertiary amine structure substituted with one aromatic ring together with the oxime type initiator can further improve the photosensitivity.

Examples of such compounds include Michler's ketone, 4,4'-bis(diethylamino)benzophenone, 2,5-bis(4'-diethylaminobenzal)cyclopentanone, 2,6-bis(4'-diethylaminobenzal)cyclohexanone, 2,6-bis(4'-dimethylaminobenzal)-4-methylcyclohexanone, 2,6-bis(4'-diethylaminobenzal)-4-methylcyclohexanone,

4,4'-bis(dimethylamino)chalcone, 4,4'-bis(diethylamino)chalcone, p-dimethylaminocinnamylideneindanone, p-dimethylaminobenzylideneindanone, 2-(p-dimethylaminophenylvinylene)benzothiazole, 2-(p-dimethylaminophenylvinylene)isonaphthothiazole, 1,3-bis(4'-dimethylaminobenzal)acetone, 1,3-bis(4'-diethylaminobenzal)-acetone and 3,3'-carbonyl-bis(7-diethylaminocoumarin); and N-phenyldiethanolamine, N-tolyldiethanolamine, N-phenylethanolamine and N-phenyl-N'-ethylethanolamine. Of these compounds, preferred are compounds represented by the formulae

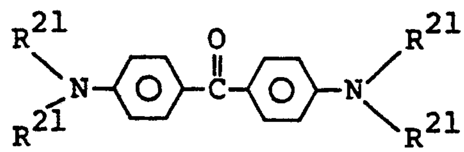

[IX]

wherein $R^{21}$ is independently a $C_{1-6}$ alkyl group, and

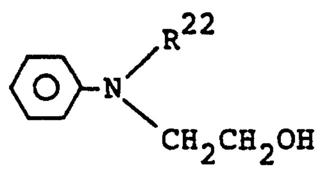

[X]

wherein $R^{22}$ is a hydrogen atom or a $C_{1-6}$ alkyl group which may have a hydroxyl group, in view of superior sensitivity.

Furthermore, in order to improve the adhesiveness of the heat-resistant photoresist film of this invention to a substrate, a silane coupling agent of the formula

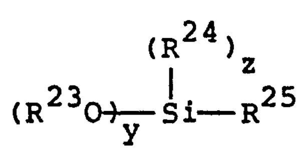

[XI]

wherein each of $R^{23}$ and $R^{24}$ is a $C_{1-6}$ alkyl group; $R^{25}$ is a hydrocarbon group which may have an oxgen atom, a

nitrogen atom or a sulfur atom; and y is 3, z is 0 or y is 2 and z is 1,
can be added to the photoresist film.

Examples of such silane coupling agents include:

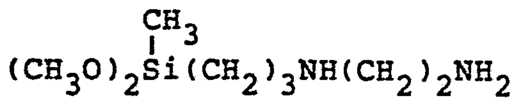 , 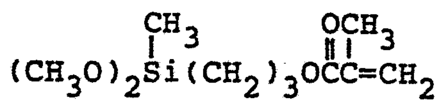 ,

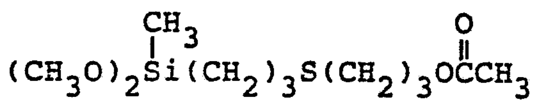 , $(CH_3O)_3Si(CH_2)_3NH_2$ ,

$(CH_3O)_3Si(CH_2)_3NH(CH_2)_2NH_2$ , $(CH_3O)_3Si(CH_2)_5CH_3$ ,

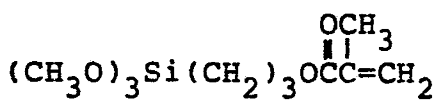 , $(CH_3O)_3SiCH_2NHCH_2CH_2NH_2$ ,

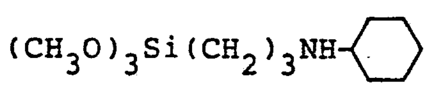 , 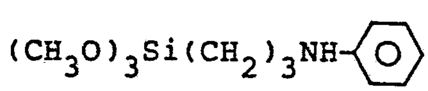 ,

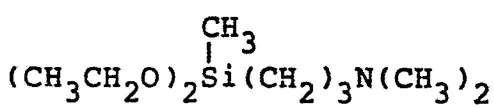 , 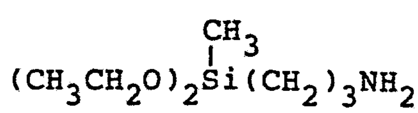 ,

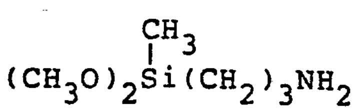 , 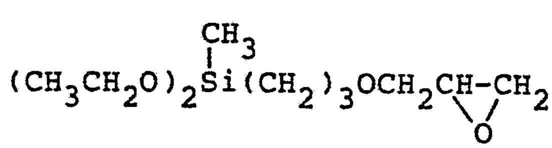 ,

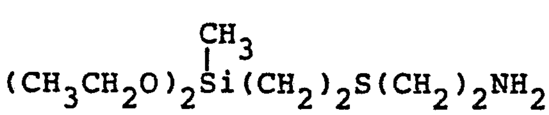 , 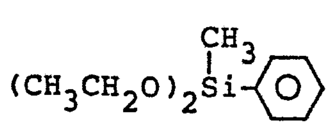

and $(CH_3CH_2O)_3Si(CH_2)_3NH_2$ .

Of these compounds, preferred are the compounds having a methacryloxy group in view of the adhesiveness and stability of the photoresist film.

The amount of the compound having a reactive carbon-carbon double bond used as component (b) in the heat-resistant photoresist film of this invention is 0.1 to 40 parts by weight, preferably 10 to 20 parts by weight based on 100 parts by weight of the polymer used as component (a). The amount of the photopolymerization initiator used as component (c) is 0.1 to 30 parts by weight, preferably 1 to 15 parts by weight based on 100 parts by weight of the polymer used as component (a). When the compound having a teriary amine structure substituted with one aromatic ring is used together with the oxime type compound as the photopolymerization initiator, its amount is 0.1 to 10 parts by weight based on 100 parts by weight of the polymer used as component (a). The amount of the silane coupling agent additionally used as component (d) is 0.1 to 20 parts by weight, preferably 0.5 to 10 parts by weight based on 100 parts by weight.

The heat-resistant photoresist film of this invention can be prepared by dissolving its components in a solvent, applying the resultant solution on one surface of a film support by means of a bar coater, a blade coater, pipe doctor blade or the like and drying the formed coating film.

The solvent which can be employed in this invention is a polar solvent having a not too high boiling point. Such solvents include cyclopentanone, cyclohexanone, dimethylacetamide, N-methylpyrrolidone and mixtures thereof.

The support film which can be employed in this invention is a substantially transparent to actinic irradiation and sufficiently strong plastic film insoluble in the solvent to employ. Such films include polyethylene terephthalate films and polypropylene films. The drying of the coating film is carried out at a temperature of 40 °C to 120 °C in a circulation oven for 5 to 60 minutes. The thickness of the coating film, i.e., the photoresist film of this invention is 1 to 200 μm, preferably 5 to 100 μm after drying. If necessary or desired, a protective film is disposed on the other surface of the photoresist film. Such films are plastic films including polyethylene terephthalate films, polypropylene films and polyethylene films. When a releasing agent such as crosslinked silicone is coated on the other surface of the film support, the photoresist film can be taken up as a roll without employing the protective film.

The photoresist film thus obtained can be laminated on a substrate after removal of the protective film if employed by applying to the surface of the substrate the surface of the photoresist film while the other surface of the photoresist film has been adhered to the film support by heating under pressure by means of a hot-roll laminator under the conditions of a roll temperature of 40 °C to 160 °C, preferably 70 °C to 140 °C and a roll pressure of 0.5 $Kg/cm^2$ to 5 $Kg/cm^2$, preferably 1 $Kg/cm^2$ to 3 $Kg/cm^2$. The photoresist film is imagewise exposed to actinic irradiation through a conventional photomask and then developed by using a developer. The film support is removed before the exposure to actinic irradiation or after the exposure to actinic irradiation and before the development. The actinic lights used in this invention include ultraviolet rays, X-rays and electron beams, though not limited thereto and of these actinic lights, preferred

are ultraviolet rays. As the light source, there can be used, for example, a low pressure mercury lamp, a high pressure mercury lamp, a super high pressure mercury lamp, a halogen lamp and a sterilization lamp. Of these light sources, preferred is a super high pressure mercury lamp.

Further, when the photoresist film after exposure to actinic irradiation is subjected to heat treatment, the polymerization of the light-hardened portions can be advanced to improve the photosensitivity. This heat treatment is carried out at a temperature of 40 °C to 120 °C, preferably 50 °C to 90 °C for 1 to 30 minutes, preferably 3 to 15 minutes.

The development is carried by removing unexposed parts of the photoresist film after exposure to actinic irradiation with a developer by an immersion method or a spray method. Preferred is a developer capable of completely removing the unexposed parts within a suitable period of time. Such developers are aprotic polar solvents including γ-butyrolactone, N-methylpyrrolidone, N-acetyl-2-pyrrolidone, N,N-dimethylformamide, N,N-dimethylacetamide, dimethyl sulfoxide, hexamethylphosphorotriamide and N-benzyl-2-pyrrolidone. The solvents can be used alone or in combination with a sond solvent. Such second solvents are alcohols including ethanol and isopropanol; aromatic hydrocarbons including toluene and xylene; ketones including methylethyl ketone and methylisobutyl ketone; esters ethyl acetate and methyl propionate; and ethers including tetrahydrofuran and dioxane.

Further, it is preferred to rinse the developed images or patterns with the above described second solvent immediately after the development.

As described above, the film support must be removed at least before the development. When a second film support soluble in the developer is provided on the surface of the photoresist film on the opposite side of the first film support and the photoresist film is laminated onto a substrate while removing the first film support, the development can be carried out without removing the second film support to reduce the peeling of the photoresist film from the substrated which occurs in the removal of the first film support. Examples of such second film supports are polystyrenes, polyvinyl acetates and polyvinyl alcohols.

All the images or patterns thus obtained are transformed into polymers having heat-resistant structure units of imide rings, oxazine dione rings and quinazoline dione rings in the heat treatment at a temperature of 200 °C to 500 °C after drying.

The following Examples are given to illustrate the present invention more specifically. However, it should be understood that the invention is in no way limited by these Examples.

In the following Reference Examples, Examples and Comparative Examples the thermal decomposition temperature and the glass transition temperature were measured according to the method as described afore and the inherent viscosity [η] was measured with a 1 wt% N-methylpyrrolidone solution of a polymer at a constant temperature of 30 °C.

Reference Example 1

147 g of 3,3',4,4'-biphenyltetracarboxylic dianhydride was mixed with 462 ml of γ-butyrolactone and 91 ml of pyridine. To the mixture thus obtained was added with stirring 136.5 g of 2-hydroxyethyl methacrylate and stirred at 20 °C for 4 hours and then left to stand for 14 hours. To this solution was added dropwise 200 ml of γ-butyrolactone containing 206.3 g of dicyclohexylcarbodiimide at 4 °C over a period of one hour. Then to the mixture was added dropwise 450 ml of γ-butyrolactone containing 89.1 g of 4,4'-diaminodiphenylmethane over a period of one hour and stirred at 20 °C for 3 hours, and subsequently 5 ml of ethanol was added to the reaction mixture and stirring was continued for 30 minutes. The reaction mixture was filtered to remove precipitated dicyclohexylurea and the filtrate was added to 10 ℓ of ethanol to give precipitates. The precipitates thus formed were isolated by filtration and dissolved in 700 ml of tetrahydrofuran and the solution was added dropwise to 6 ℓ of deionized water to give precipitates. The precipitates were isolated by filtration and dried under vacuum to give 250 g of a polymer (yield 67 %). This polymer is designated as P-1. The inherent viscosity of P-1 was 0.18 and the thermal decomposition temperature of the P-1 coating film was 405 °C and the glass transition temperature was 350 °C.

Reference Example 2

A solution was prepared by dissolving 96.7 g of 3,3',4,4'-biphenyltetracarboxylic dianhydride in 300 ml of N,N-dimethylacetamide. To this solution was added 200 ml of N,N-dimethylacetamide containing 79.1 g of 2,2'-dimethyl-6,6'-diethyl-4,4'-diaminodiphenylmethane and stirred at 20 °C for 4 hours. To the solution thus

obtained was added 85.3 g of glycidylmethacrylate and stirred at 70 °C for 18 hours to give a reaction solution. Then the reaction solution was added dropwise to a mixed solution of 2 ℓ of ethanol and 4 ℓ of water to form precipitates, followed by the isolation of the precipitates. The isolated precipitates were dissolved in 800 ml of tetrahydrofuran and the solution thus obtained was added dropwise to 10 ℓ of deionized water to precipitate a polymer. Subsequently the polymer was separated by filtration and dried under vacuum to give 175 g of a polymer (yield 67 %). This polymer is designated as P-2. The inherent viscosity of P-2 was 0.13 and the thermal decomposition temperature of the P-2 coating film was 360 °C and the glass transition temperature was 300 °C.

Reference Example 3

A solution was prepared by dissolving 93 g of 3,3',4,4'-biphenylethertetracarboxylic dianhydride in 300 ml of N,N-dimethylacetamide. To this solution was added 200 ml of N,N-dimethylacetamide containing 69.4 g of 3,3'-diaminodiphenyl sulfone and stirred at 20 °C for 4 hours. To the solution thus obtained was added 94.2 g of 2-(N,N'-dimethylamino)ethyl methacrylate and stirred at 20 °C for 4 hours to give a solution. This solution is designated at Q-1. The viscosity of Q-1 at 23 °C was 40 poise and the thermal decomposition temperature of the Q-1 coating film was 350 °C and the glass transition temperature was 340 °C.

Reference Examples 4 to 8

In the same manner as in Reference Example 1 were prepared polymers (P-3, P-4, P-5, P-6 and P-7) using the starting materials as set forth in Table 2.

The inherent viscosity [η] of each of the polymers and the thermal decomposition temperature and glass transition temperature of each of the polymer coating films were set forth in Table 2.

Table 2

| Reference Example No. | Polymer No. | Starting Materials: Alcohol (g) | Starting Materials: Acid Anhydride (g) | Starting Materials: Diamine (g) | Properties of Polymer: Inherent Viscosity [η] | Properties of Polymer: Thermal Decomposition Temperature (°C) | Properties of Polymer: Glass Transition Temperature (°C) |
|---|---|---|---|---|---|---|---|
| 4 | P-3 | HEA 121.8 | BTDA 161 | DPM 89.1 | 0.13 | 400 | 320 |
| 5 | P-4 | HEMA 136.5 | -do- | DPE 90 | 0.24 | 410 | 325 |
| 6 | P-5 | -do- | BPDA 117.6 PMDA 21.8 | DMM 81.4 DPE 18 | 0.21 | 390 | 340 |
| 7 | P-6 | -do- | BTDA 161 | DPE 45 DEE 69.8 | 0.19 | 380 | 305 |
| 8 | P-7 | NMA 106 | BTDA 161 | DEE 139.6 | 0.22 | 370 | 280 |

HEA : 2-Hydroxyethyl acrylate
HEMA: 2-Hydroxyethyl methacrylate
NMA : N-Methylolacrylamide
BPDA: 3,3',4,4'-Biphenyltetracarboxylic dianhydride
BTDA: 3,3',4,4'-Benzophenonetetracarboxylic dianhydride
PMDA: Pyromellitic dianhydride
DPM: 4,4'-Diaminodiphenylmethane
DPE : 4,4'-Diaminodiphenylether
DMM : 4,4'-Diamino-3,3'-dimethyl-5,5'-diethyldiphenylmethane
DEE : 4,4'-Diamino-3,3',5,5'-tetraethyldiphenylmethane

0254230

In the following Tables 3, 4 and 5 are shown the compounds having a reactive carbon-carbon double bond, the photopolymerization initators and the silane coupling agents which were employed in the following Examples and Comparative Examples.

## Table 3

Compound Having a Reactive Carbon-Carbon Double Bond

| No. | Compound |
|---|---|
| M-1 | $CH_3C(CH_2O\overset{O}{\overset{\|}{C}}CH{=}CH_2)_3$ |
| M-2 | $CH_2{=}CH\overset{O}{\overset{\|}{C}}(OCH_2CH_2)_4O\overset{O}{\overset{\|}{C}}CH{=}CH_2$ |
| M-3 | $CH_2{=}CH\overset{O}{\overset{\|}{C}}NHCH_2NH\overset{O}{\overset{\|}{C}}CH{=}CH_2$ |
| M-4 | $CH_2{=}CH\overset{O}{\overset{\|}{C}}OCH_2\overset{CH_3}{\overset{\|}{C}}HO\overset{O}{\overset{\|}{C}}NH(CH_2)_6NH\overset{O}{\overset{\|}{C}}O\overset{CH_3}{C}HCH_2O\overset{O}{\overset{\|}{C}}CH{=}CH_2$ |
| M-5 | 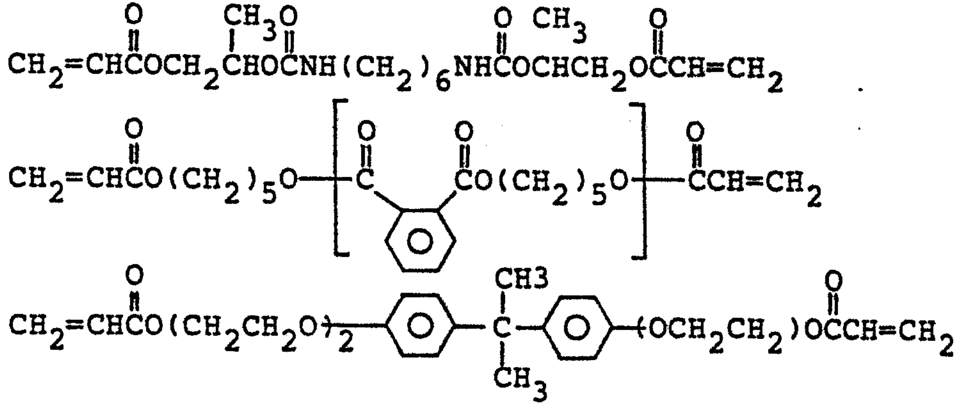 |
| M-6 | |

Table 4

Photopolymerization Initiator

| No. | Compound |
| --- | --- |
| K-1 | 1-Phenylpropanedione-2-(O-ethoxycarbonyl)oxime |
| K-2 | 1-Phenylpropanedione-2-(O-benzoyl)oxime |
| K-3 | 1-Phenyl-3-ethoxypropanetrione-2-(O-ethoxy-carbonyl)oxime |
| K-4 | 1-Phenyl-3-ethoxypropanetrione-2-(O-benzoyl)oxime |
| K-5 | 1-Phenyl-3-mesitylpropanepropanetrione-2-(O-ethoxycarbonyl)oxime |
| K-6 | Michler's ketone |
| K-7 | 4,4'-Bis(diethylamino)benzophenone |
| K-8 | N-Phenyl-N'-ethanolamine |
| K-9 | N-Phenyldiethanolamine |

Table 5

Silane Coupling Agent

| No. | Compound |
| --- | --- |
| S-1 | 3-Methacryloxypropyltrimethoxysilane |
| S-2 | 3-Methacryloxypropyldimethoxymethylsilane |
| S-3 | 3-Glycidoxypropyldiethoxymethylsilane |

Example 1

A solution was prepared by dissolving 100 g of P-1 as obtained in Reference Example 1 as the polymer, 13 g of M-1 as the compound having a reactive carbon-carbon double bond, 4 g of K-2, 2 g of K-7 and 3 g of K-8 as the photopolymerization initiators and 3 g of S-1 as the coupling agent in a mixed solvent of 60 g of N-methylpyrrolidone and 90 g of cyclopentanone. This solution was applied on a 25-μm thick polyethylene terephthalate film (hereinafter referred to as "PET" film) by means of an automatic applicator and dried at 70 °C for 30 minutes in a circulation oven to form a uniform 42-μm thick coating film. This supported coating film was laminated onto a 1 mm (thickness) x 10 cm (width) x 20 cm (length) glass sheet substrate by using a hot roll laminator heated at 130 °C under a roll pressure of 2 $Kg/cm^2$ at a rate of 0.5 m/minute. After allowing to cool, the PET film support was peeled off and the coating film was exposed to irradiation from an ultra-high pressure mercury lamp (7 $mW/cm^2$) through a photomask for 2 minutes in a nitrogen atmosphere, then subjected to heat treatment at 70 °C for 5 minutes, cooled to room temperature, subsequently treated with a developing mixture of N-methylpyrrolidone and xylene (volume ratio 1:1) and further rinsed with isopropanol to give sharp patterns having a 1:1 line and space resolution of 60 μm.

Then the substrate bearing the patterns thus obtained thereon was subjected to heat treatment at 140 °C for 2 hours and 400 °C for one hour in a nitrogen atmosphere to give sharp polyimide patterns.

Examples 2 to 9

The same procedures as in Example 1 were repeated except that the polymer, the compound having a reactive carbon-carbon double bond, the photopolymerization initiators and the coupling agent as set forth in Tables 2 to 5, respectively were employed.

The results are shown in Table 6.

Table 6

| Example No. | Polymer (100g) | Compound Having a Reactive Carbon-Carbon Double Bond | (g) | Photopolymerization Initiator | (g) | Silane Coupling Agent | (g) | Thickness of Coating Film (μm) | Exposure Time (second) | Resolution* (μm) |
|---|---|---|---|---|---|---|---|---|---|---|
| 2 | P-3 | M-2 | 10 | K-1<br>K-6<br>K-9 | 5<br>3<br>2 | S-2 | 2 | 20 | 60 | 30 |
| 3 | P-4 | M-2 | 15 | K-4<br>K-7<br>K-9 | 6<br>3<br>2 | —— | | 50 | 60 | 60 |
| 4 | P-5 | M-3 | 6 | K-3<br>K-7<br>K-8 | 4<br>2<br>1 | S-3 | 2 | 40 | 180 | 60 |
| 5 | P-2 | M-5 | 9 | K-5<br>K-6<br>K-9 | 3<br>3<br>3 | S-1 | 4 | 70 | 120 | 100 |
| 6 | P-6 | M-6 | 12 | K-4<br>K-7<br>K-9 | 6<br>3<br>2 | S-2 | 3 | 60 | 100 | 140 |
| 7 | P-4 | M-4 | 13 | K-5<br>K-7<br>K-9 | 7<br>2<br>3 | S-3 | 2 | 50 | 80 | 80 |

Table 6 (-continued)

| Example No. | Polymer (100g) | Compound Having a Reactive Carbon-Carbon Double Bond | (g) | Photopolymerization Initiator | (g) | Silane Coupling Agent (g) | Thickness of Coating Film (μm) | Exposure Time (second) | Resolution* (μm) |
|---|---|---|---|---|---|---|---|---|---|
| 8 | P-6 | M-6 | 10 | K-4<br>K-7<br>K-9 | 8<br>2<br>2 | — | 30 | 60 | 60 |
| 9 | P-7 | M-2 | 11 | K-2<br>K-6<br>K-8 | 9<br>3<br>4 | — | 20 | 70 | 30 |

* Line width of 1:1 line and space resolution

Example 10

A solution was prepared by dissolving 14 g of M-2 as the compound having a reactive carbon-carbon double bond (b), 5 g of K-3, 3 g of K-6 and 3 g of K-8 as the photopolymerization initiators and 3 g of S-1 as the silane coupling agent in 294 g of the Q-1 solution as obtained in Reference Example 3. This solution was applied on a 25-μm PET film by means of an automatic applicator and dried at 70 °C for 2 hours in a circulation oven to form a uniform 15-μm thick coating film. This supported coating film was laminated onto a 1 mm (thickness) x 10 cm (width) x 10 cm (length) glass sheet substrate by using a hot roll laminator heated at 130 °C under a roll pressure of 2 $Kg/cm^2$ at a rate of 0.5 m/minute. After allowing to cool, the PET film support was peeled off and the coating film was exposed to irradiation from an ultra-high pressure mercury lamp (7 $mW/cm^2$) through a photomask for 80 seconds in a nitrogen atmosphere, then treated with a developing mixture of N-methylpyrrolidone and ethanol (volume ratio 1:1) and further rinsed with ethanol to give sharp patterns having a 1:1 line and space resolution of 40 μm.

Then the substrate bearing the patterns thus obtained thereon was subjected to heat treatment at 140 °C for 2 hours and 400 °C for one hour in a nitrogen atmosphere to give sharp polyimide patterns.

Comparative Example 1

The same procedures of Reference Example 1 were repeated except that 109 g of pyromellitic dianhydride as the acid anhydride, 136.5 g of 2-hydroxyethyl methacrylate as the alcohol and 90 g of 4,4'-diaminodiphenylether as the diamine were employed

and as the result, a polymer (P-7) was prepared. This polymer had an inherent viscosity [η] of 0.19 and the thermal decomposition temperature of the P-7 coating film ws 450 °C and the glass transition temperature was 400 °C.

Then a solution was prepared by dissolving 100 g of P-7, 13 g of M-1 as the compound having a reactive carbon-carbon double bond, 4 g of K-2, 2 g of K-7 and 3 g of K-8 as the photopolymerization initiators and 3 g of S-1 as the silane coupling agent in a mixed solvent of 60 g of N-methylpyrrolidone and 90 g of cyclopentanone. This solution was applied on a 25-μm PET by means of an automatic applicator and dried at 70 °C for 30 minutes in a circulation oven to form a uniform 39-μm thick coating film. This supported coating film was laminated onto a 1 mm (thickness) x 10 cm (width) x 20 cm (length) glass sheet substrate by using a hot roll laminator heated at 130 °C under a roll pressure of 2 $Kg/cm^2$ at a rate of 0.5 m/minute. As the laminate was allowed to cool, the supported coating film peeled off from the substrate.

CLAIMS

1. A heat-resistant photoresist film comprising, as the essential components,

(a) a polymer consisting of recurring units represented by the formula

$$\underset{(A)_2}{\underset{|}{-X}}-Z-Y-Z- \qquad [I]$$

wherein X is a tetravalent $C_{6-30}$ carbocyclic group or heterocyclic group;

Y is a divalent $C_{6-30}$ carbocyclic group or heterocyclic group;

Z is $-\underset{O}{\underset{\|}{C}}-NH-$ , $-NH-\underset{O}{\underset{\|}{C}}-NH-$ or $-O-\underset{O}{\underset{\|}{C}}-NH-$ ;

A is -COOR or $-COO^{\ominus}R'^{\oplus}$ wherein each of R and R' is a compound having a reactive carbon-carbon double bond; and

A is in the position ortho or peri with respect to the Z group,

said polymer being capable of transforming into a polymer having a thermal decomposition temperature of at least 350 °C and a glass transition temperature of at most 350 °C in the heat treatment;

(b) a compound having a reactive carbon-carbon double bond, and

(c) a photopolymerization initiator,

and optionally

(d) a silane coupling agent represented by the formula :

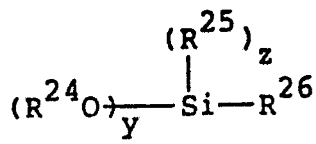

wherein each of $R^{24}$ and $R^{25}$ is a $C_{1-6}$ alkyl group; $R^{26}$ is a hydrocarbon group which may have an oxygen atom, a nitrogen atom or a sulfur atom; and y is 3, z is 0 or y is 2 and z is 1.

2. A heat-resistant photoresist film of Claim 1, wherein a plastic film support substantially transparent to actinic irradiation is disposed on one surface of the photoresist film.

3. A heat-resistant photoresist film of Claim 2, wherein the plastic film support is a polyethylene terephthalate film or a polypropylene film.

4. A heat-resistant photoresist film of Claim 2, wherein a plastic protective film is disposed on the other surface of the photoresist film.

5. A heat-resistant photoresist film of Claim 4, wherein the protective film is a polyethylene terephthalate film, a polypropylene film or a polyethylene film.

6. A heat-resistant photoresist film of any of the Claims 1 to 5 having a thickness of 1 to 200 μm.

7. A heat-resistant photoresist film of Claim 6 having a thickness of 5 to 100 μm.

8. A heat-resistant photoresist film of any of the claims 1 to 7, wherein the content of the compound (b) is 0.1 to 40 parts by weight based on 100 parts by weight of the polymer (a).

9. A heat-resistant photoresist film of Claim 8, wherein the content of the compound (b) is 10 to 20 parts by weight based on 100 parts by weight of the polymer (a).

10. A heat-resistant photoresist film of any of the claims 1 to 9, wherein the content of the photopolymerization initiator (c) is 0.1 to 30 parts by weight based on 100 parts by weight of the polymer (a).

11. A heat-resistant photoresist film of Claim 10, wherein the content of the photopolymerization initiator (c) is 1 to 15 parts by weight based on 100 parts by weight of the polymer (a).

12. A heat-resistant photoresist film of any of the Claims 1 to 11, wherein the content of the silane coupling agent (d) is 0.1 to 20 parts by weight based on 100 parts by weight of the polymer (a).

13. A heat-resistant photoresist film of Claim 12, wherein the content of the silane coupling agent (d) is 0.5 to 10 parts by weight based on 100 parts by weight of the polymer (a).

14. A heat-resistant photoresist film of any of the claims 1 to 13, wherein X in the formula [I] is a tetravalent aromatic ring or a tetravalent condensed polycyclic ring.

15. A heat-resistant photoresist film of any of the claims 1 to 13, wherein X in the formula [I] is a group represented by the formula

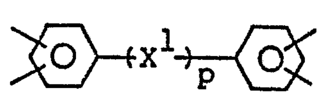

wherein $X^1$ is $-CH_2-$ , $-\overset{O}{\overset{\|}{C}}-$ , $-\underset{\overset{\|}{O}}{\overset{O}{\overset{\|}{S}}}-$ , -O- or $-\underset{CF3}{\overset{CF_3}{C}}-$ and p is 0 or 1.

16. A heat-resistant photoresist film of Claim 15, wherein X in the formula [I] is a group represented by the formula

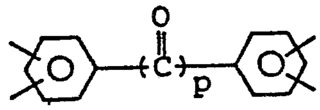

wherein p is 0 or 1.

17. A heat-resistant photoresist film of any of the claims 1 to 16, wherein Y in the formula [I] is one of the groups represented by the formulae

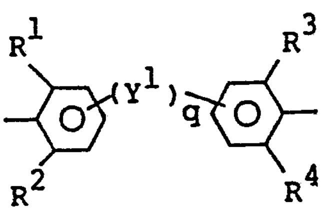 , 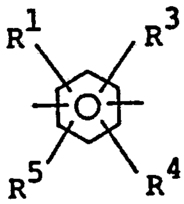 , 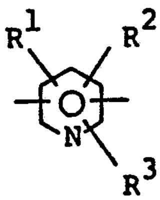 ,

wherein $Y^1$ is $-CH_2-$ , $-\overset{O}{\overset{\|}{C}}-$ , $-\underset{\overset{\|}{O}}{\overset{O}{\overset{\|}{S}}}-$ , -O- , -S- ,

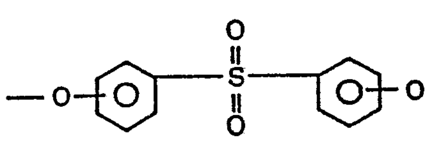 , 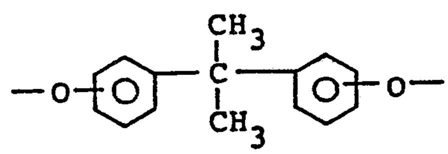 ,

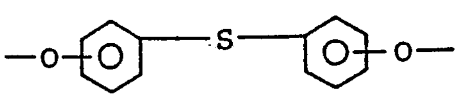 or 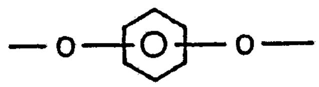 ;

each of $R^1$, $R^2$, $R^3$ and $R^4$ is a hydrogen atom, a $C_{1-6}$ alkyl group or $-CONH_2$; and q is 0 or 1.

18. A heat-resistant photoresist film of Claim 17, wherein Y in the formula [I] is a group represented by the formula

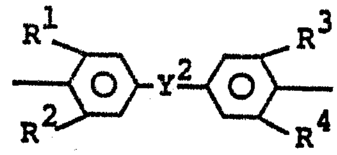

wherein $Y^2$ is $-CH_2-$ or $-O-$ and each of $R^1$, $R^2$, $R^3$ and $R^4$ is a hydrogen atom, a $C_{1-6}$ alkyl group or $-CONH_2$.

19. A heat-resistant photoresist film of any of the Claims 1 to 18, wherein Z is $-\underset{\underset{O}{\|}}{C}-NH-$ .

20. A heat-resistant photoresist film of any of the claims 1 to 19, wherein R in A of the formula [I] is a group represented by the formula

$$-R^6\!\left(W-\overset{\overset{O}{\|}}{C}\right)_r\!-\overset{\overset{R^5}{|}}{C}=CH_2$$

wherein $R^5$ is a hydrogen atom or a methyl group; $R^6$ is an alkyl group which may have an ether bond or a hydroxyl group; w is -O- or -NH- ; and r is 0 or 1.

21. A heat-resistant photoresist film of Claim 20, wherein R in A of the formula [I] is a group represented by the formula

$$-R^7-O-\overset{\overset{O}{\|}}{C}-\overset{\overset{R^5}{|}}{C}=CH_2$$

wherein $R^5$ is a hydrogen atom or a methyl group and $R^7$ is $-CH_2CH_2-$ , $-CH_2CH_2OCH_2CH_2-$ or $-CH_2\overset{\overset{OH}{|}}{C}HCH_2-$ .

22. A heat-resistant photoresist film of Claim 21, wherein R in A of the formula [I] is a 2-methacryloxyethyl group or a 2-acryloxyethyl group.

23. A heat-resistant photoresist film of any of the Claims 1 to 19, wherein $R'^{+}$ in $-COO^{-}R'^{+}$ of A in the formula [I] is a group represented by the formula

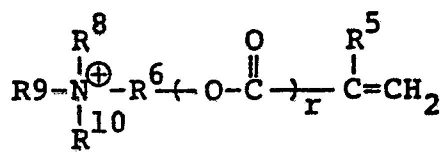

wherein $R^5$ is a hydrogen atom or a methyl group; $R^6$ is an alkyl group which may have an ether bond or a hydroxyl group; each of $R^8$, $R^9$ and $R^{10}$ is a hydrogen atom or a $C_{1-6}$ alkyl group and r is 0 or 1.

24. A heat-resistant photoresist film of Claim 23, wherein $R'^{\oplus}$ in $-COO^{\ominus}R'^{\oplus}$ of A in the formula [I] is a group represented by the formula

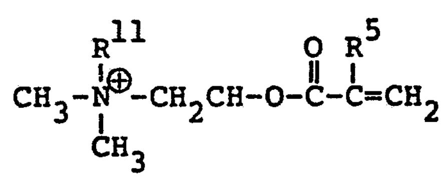

wherein each of $R^5$ and $R^{11}$ is a hydrogen atom or a methyl group.

25. A heat-resistant photoresist film of any of the Claims 1 to 24, wherein the polymer (a) is a polymer capable of transforming into a polymer having

a glass transition temperature of at most 330 °C in the heat treatment.

26. A heat-resistant photoresist film of any of the Claims 1 to 24, wherein the polymer (a) is a polymer capable of transforming into a polymer having a thermal decomposition temperature of at least 400 °C and a glass transition temperature of at most 350 °C in the heat treatment.

27. A heat-resistant photoresist film of any of the Claims 1 to 26, wherein the compound (b) is a compound having a terminal group represented by the formula

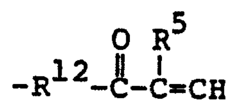

wherein $R^{12}$ is -O- or -NH- and $R^5$ is a hydrogen atom or a methyl group.

28. A heat-resistant photoresist film of Claim 27, wherein the compound (b) is a compound having a plurality of terminal acryloxy groups.

29. A heat-resistant photoresist film of any of the Claims 1 to 28, wherein the photopolymerization initiator (c) is an oxime type compound represented by the formula

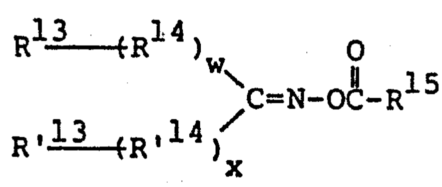

wherein each of $R^{13}$ and $R'^{13}$ is a $C_{1-6}$ alkyl group, a $C_{6-20}$ aromatic hydrocarbon or a group represented by the

formula 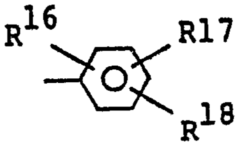 (wherein each of $R^{16}$, $R^{17}$ and $R^{18}$ is a hydrogen atom, a $C_{1-6}$ alkyl group or a $C_{1-6}$ alkoxy group; each of $R^{14}$ and $R'^{14}$ is 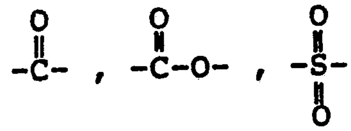 or 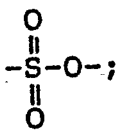; $R^{15}$ is a $C_{1-6}$ alkyl group, a $C_{1-6}$ alkoxy group or a $C_{6-20}$ aromatic hydrocarbon; and each of w and x is 0 or 1.

30. A heat-resistant photoresist film of Claim 29, wherein the photopolymerization initiator (c) is an oxime type compound represented by the formula

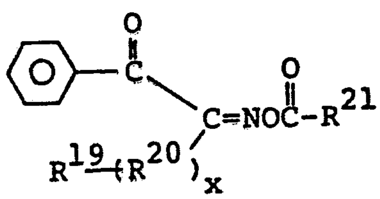

wherein $R^{19}$ is $-CH_3$, $-OCH_2CH_3$, 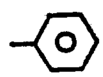 or 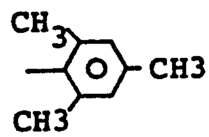;

$R^{20}$ is 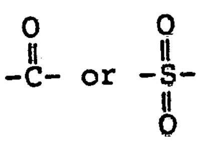; $R^{21}$ is 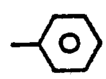 or $-OCH_2CH_3$; and x is 0 or 1.

31. A heat-resistant photoresist film of Claim 29 or Claim 30, wherein together with the oxime type compound is employed a compound having a tertiary amine structure substituted with one aromatic ring.

32. A heat-resistant photoresist film of Claim 31, wherein the compound having a tertiary amine structure substituted with one aromatic ring is at least one of the compounds represented by the formulae

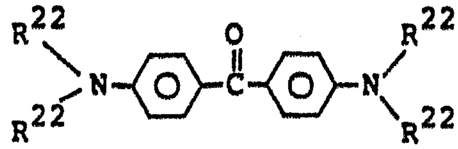 and 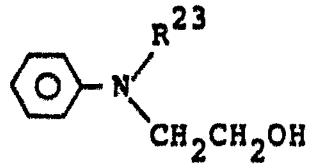

wherein $R^{22}$ is independently a $C_{1-6}$ alkyl group and $R^{23}$ is a hydrogen atom or a $C_{1-6}$ alkyl group which may have a hydroxyl group.

33. A heat-resistant photoresist film of Claim 31 or 32, wherein the content of the compound having a tertiary amine structure substituted with one aromatic ring is 0.1 to 10 parts by weight based on 100 parts by weight of the polymer (a).

34. A heat-resistant photoresist film of any of the Claims 1 to 23, wherein the silane coupling agent agent (d) is a compound represented by the formula

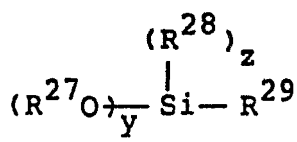

wherein $R^{27}$ is $-CH_3$ or $-C_2H_5$ ; $R^{28}$ is $-CH_3$ ; $R^{29}$ is

$-(CH_2)_5CH_3$, 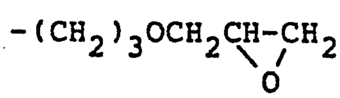 or 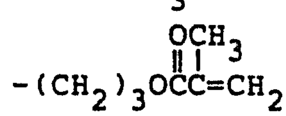 ; and

y is 3, z is 0 or y is 2 and z is 1.